# FASCICULE DE BREVET EUROPEEN

(11) **EP 0 243 239 B1**
(45) Date de publication et mention de la délivrance du brevet: **22.06.1994**
(21) Numéro de dépôt: 87400838.6
(22) Date de dépôt: 14.04.1987
(51) Int. Cl.: H05K 7/20

(54) **Installation de transfert de chaleur entre un fluide et un organe à refroidir ou réchauffer, par mise en dépression du fluide par rapport à la pression atmosphérique**
Anlage zur Übertragung der Wärme zwischen einer Flüssigkeit und einem Organ zum Abkühlen oder zum Erwärmen durch Herabsetzen des Drucks der Flüssigkeit in Bezug auf den atmosphärischen Druck
Installation for transferring heat between a fluid and an organ to be chilled or heated by lowering the fluid pressure with respect to atmospheric pressure

(30) Priorité: 23.04.1986 FR 8605846
(43) Date de publication de la demande: 28.10.1987
(73) Titulaire: Bosteels, Michel, F-01630 Saint-Genis (FR)
(72) Inventeur: Bosteels, Michel, F-01630 Saint-Genis (FR)
(74) Mandataire: Robert, Jean S.

(56) Documents cités:
- US-A- 3 481 393
- US-A- 3 757 530
- US-A- 3 992 894
- US-A- 4 698 728

## Description

La présente invention a pour objet une installation de transfert de chaleur entre un fluide et un organe à refroidir ou à réchauffer.

US-A-3 481 393 révèle par exemple un système modulaire de refroidissement dans lequel une phiralité d'éléments de refroidissement sont connectés en série au moyen de tuyaux flexibles.

Le but de la présente invention est de fournir une installation de transfert de chaleur par fluide dans laquelle toute fuite dudit fluide soit exclue.

Ce but est atteint grâce au fait que l'installation suivant l'invention comprend un réservoir de fluide ouvert à la pression atmosphérique, une enceinte qui débouche à sa partie inférieure dans ledit réservoir et dont une partie au moins de la surface intérieure est constituée par ledit organe à refroidir ou à réchauffer, et une pompe à vide agissant sur ledit fluide pour le mettre en dépression par rapport à la pression atmosphérique.

De préférence, cette enceinte comporte au moins un caisson parallélépipédique ou un échangeur eau/air dont une grande face au moins est constituée par l'organe à refroidir ou à réchauffer et qui est raccordé par une canalisation au réservoir spécifié ci-avant.

Avantageusement, l'organe à refroidir ou à réchauffer est monté de manière amovible sur le caisson correspondant avec interposition éventuelle d'un joint adéquat. On comprend que cette disposition facilite grandement le montage et le démontage éventuel de l'installation.

Dans une forme de réalisation particulièrement avantageuse de la présente invention, l'installation comprend un conduit montant aux parties inférieure et supérieure duquel sont raccordées, respectivement, une canalisation d'amenée et une canalisation de sortie, les caissons spécifiés ci-avant étant raccordés par des canalisations correspondantes à ces canalisations d'amenée et de sortie.

De préférence, la partie supérieure du conduit montant dont il vient d'être question comporte la pompe à vide commandée par un contrôleur de niveau, ce qui permet un remplissage aisé de l'installation, ainsi que cela sera expliqué plus loin.

Avantageusement, une pompe de circulation du fluide de transfert et/ou un échangeur de chaleur sont montés à l'entrée de la canalisation d'amenée spécifiée ci-avant.

Dans une forme d'utilisation particulièrement avantageuse de l'invention, l'organe à refroidir ou à réchauffer est constitué par une carte électronique, notamment du genre de celles qui sont montées dans les ordinateurs. Dans ce cas, le transfert de chaleur se fait bien entendu dans le sens du refroidissement, le fluide de transfert employé étant, par exemple, un fluoro-carbone à faible tension de vapeur tel que celui, de formule C₆F₁₄, qui est commercialisé sous la dénomination FC75. De tels produits présentent une résistivité très élevée, c'est-à-dire supérieure à 10¹⁵ Ohm/cm, ce qui permet de les mettre directement en contact avec les composants à refroidir.

La description qui va suivre, et qui ne présente aucun caractère limitatif, permettra de bien comprendre comment la présente invention peut être mise en pratique. Elle doit être lue en regard des dessins annexés, parmi lesquels :
- La figure 1 représente un schéma de principe d'une installation de transfert de chaleur selon l'invention dans l'une de ses formes de réalisation ; et :
- Les figures 2 et 3 montrent également des schémas de principe et elles représentent des variantes d'une partie de l'installation de la figure 1.

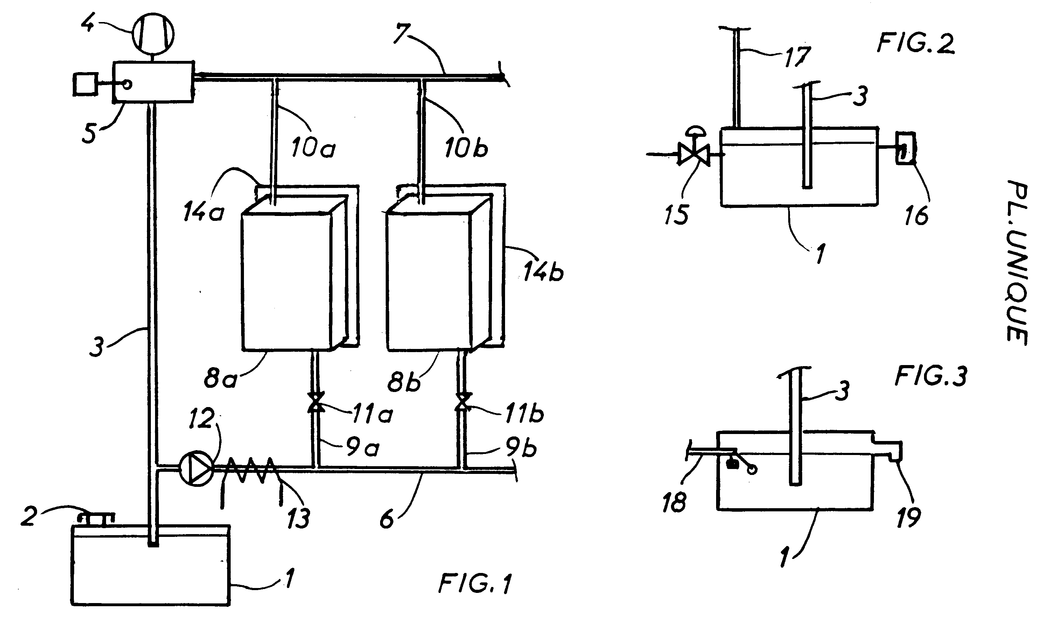

Comme on le voit sur la figure 1, l'installation selon l'invention comprend à sa partie inférieure un réservoir de fluide de transfert de chaleur 1 qui communique avec l'air extérieur par l'intermédiaire d'un évent 2, de sorte que la surface libre du fluide dans le réservoir 1 se trouve à la pression atmosphérique.

Un conduit montant 3 plonge dans le réservoir 1 et il est raccordé à sa partie supérieure à une pompe à vide 4 par l'intermédiaire d'un contrôleur de niveau 5 dont le rôle sera précisé plus loin.

Une canalisation d'amenée 6 sensiblement horizontale est branchée sur le conduit 3 à sa partie basse et une canalisation de sortie 7, elle aussi sensiblement horizontale, est raccordée à ce même conduit montant 3 à la hauteur du contrôleur de niveau 5. Entre les canalisations d'amenée 6 et de sortie 7 sont montés des éléments 8a, 8b, etc., par l'intermédiaire de canalisations de raccordement 9a, 9b, etc. reliant les éléments 8a, 8b, etc. correspondants à la canalisation d'amenée 6 et de canalisations de raccordement 10a, 10b, etc. reliant les éléments 8a, 8b, etc. correspondants à la canalisation de sortie 7. Des vannes 11a, 11b, etc. sont respectivement montées sur les canalisations de raccordement 9a, 9b, etc. Enfin, une pompe de circulation 12 et un échangeur de chaleur 13 peuvent être montés à l'entrée de la canalisation d'amenée 6.

Pour leur part, chacun des éléments 8a, 8b, etc. est constitué par l'organe à refroidir ou à chauffer qui est par exemple une carte électronique d'ordinateur 14a, 14b, etc. et sur lequel s'applique un caisson parallélépipédique 15a, 15b, etc. dont la grande face correspondante est ouverte et qui est muni d'orifices pour le raccordement des canalisations 9a, 9b, etc. et 10a, 10b, etc. Des joints appropriés non représentés peuvent être interposés entre les organes 14a, 14b, etc. et les caissons correspondants 8a, 8b, etc., lesquels sont reliés entre eux par tout moyen convenable comme des vis, des pinces, ou tout organe analogue.

Le mode de fonctionnement de cette installation est le suivant : on commence par remplir de fluide le réservoir 1, puis on enclenche la pompe à vide 4, de sorte que le fluide se trouve aspiré dans l'ensemble de l'installation, et le contrôleur de niveau 5 arrête la pompe 4 dès que le niveau est suffisant. Grâce à la pompe de circulation 12, le fluide traverse les éléments 8a, 8b, etc. où il refroidit ou chauffe les organes 14a, 14b, etc. Du fait que la pression de ce fluide est inférieure à la pression atmosphérique à ce niveau, toute fuite est impossible.

Dans le cas où l'on veut éviter toute perte par évaporation, l'évent 2 permettant la mise à la pression atmosphérique du réservoir 1 peut être remplacé par un dispositif plus élaboré qui est représenté sur la figure 2 et qui comprend un détendeur 15 pouvant être alimenté en air, en gaz neutre ou en tout autre gaz en fonction de la nature du fluide employé, et une soupape de surpression 16 raccordée à une conduite d'évacuation ou à un système de récupération, ces deux organes ne travaillant que lors de variations de la pression atmosphérique ou de la température, ou encore en cas d'entrée d'air dans le circuit.

Dans la variante qui est représentée sur la figure 3 et qui correspond plus particulièrement au cas où le fluide de transfert de chaleur est de l'eau, on utilise un simple réservoir à niveau constant dont la capacité peut être inférieure à celle de l'installation. Ce réservoir est alors muni d'une arrivée d'eau 18 comprenant un robinet à flotteur et d'un trop-plein 19.

On indiquera encore certaines limites d'emploi du système qui vient d'être décrit : la première est statique, et il s'agit de la tension de vapeur du liquide employé en fonction de la température. C'est ainsi que, pour de l'eau à 6O°C, la hauteur maximale du système ne peut théoriquement pas dépasser 8 mètres pour une pression atmosphérique égale à un bar. Une autre limite est d'ordre dynamique : si l'on emploie la pompe de circulation 12, il faut tenir compte des pertes de charge pour déterminer les zones où l'on veut maintenir une pression relative négative.

Lorsqu'un défaut d'étanchéité prend naissance dans l'installation selon l'invention, et s'il s'agit d'une fuite de faible valeur, elle se traduit par une entrée d'air qui s'accumule dans le contrôleur de niveau 5. Dès que le niveau du liquide atteint la limite inférieure prévue pour ce contrôleur, la pompe 4 s'enclenche à nouveau et elle évacue l'air accumulé. Le contrôle du temps de marche de la pompe 4 permet de déterminer avec précision la valeur des fuites, ces dernières ne devenant gênantes que si la pompe ne peut plus suffire à évacuer la quantité d'air introduite.

Au contraire, dans le cas extrême où se produit la rupture franche d'un conduit, la pompe 4 est incapable d'aspirer l'air qui s'introduit dans l'installation, et la pression atmosphérique tend à s'établir dans le circuit. La seule conséquence d'un incident de ce genre est le retour du liquide vers le réservoir 1, retour qui a lieu pratiquement sans perte de liquide.

Il y a lieu de noter enfin que l'un au moins des caissons 8 pourrait être remplacé par un écahngeur de chaleur eau/air non représenté.

## Revendications

1. Installation de transfert de chaleur entre un fluide et un organe à refroidir ou à réchauffer, caractérisée par le fait qu'elle comprend un réservoir de fluide (1) ouvert à la pression atmosphérique, une enceinte qui débouche à sa partie inférieure dans ledit réservoir (1) et dont une partie au moins de la surface intérieure est constituée par ledit organe à refroidir ou à réchauffer (14a, 14b,), et une pompe à vide (4) agissant sur ledit fluide pour le mettre en dépression par rapport à la pression atmosphérique.

2. Installation suivant la revendication 1, caractérisée par le fait qu'elle comprend un conduit montant (3) aux parties inférieure et supérieure duquel sont raccordées, respectivement, une canalisation d'amenée (6) et une canalisation de sortie (7), l'enceinte comprenant des caissons (8a, 8b, etc...) raccordés par des canalisations (10a, 10b, etc...; 9a, 9b, etc...) à des canalisations d'amenée (6) et de sortie (7), la partie supérieure du conduit montant (3) comportant la pompe à vide (4).

3. Installation suivant la revendication l, caractérisée par le fait que la pompe à vide (4) est commandée par un contrôleur de niveau (5).

## Claims

1. Installation for transferring heat between a fluid and an organ to be chilled or heated, characterized by the fact that it comprises a tank for the fluid (1) open to the atmospherical pressure, a chamber which opens at its lower portion into the said tank (1) and at least a part of the inner surface of which is constituted by the said organ to be chilled or heated (14a, 14b), and a vacuum pump (4) acting on the said fluid for putting it under depression with respect to the atmospherical pressure.

2. Installation according to claim 1, characterized by the fact that it comprises an ascending conduct (3) at the lower and upper portions of which are connected, respectively, an input line (6) and an ouput line (7), the chamber comprising caissons (8a, 8b, etc...) connected through lines (10a, 10b, etc...; 11a, 11b, etc...) to the input (6) and output (7) lines, the upper portion of the ascending conduct (3) comprising the vacuum pump (4).

3. Installation according to claim 1, characterized by the fact that the vacuum pump (4) is controlled by a level checking means (5).

## Patentansprüche

1. Anlage zum Übertragen von Wärme zwischen einer Flüssigkeit und einem abzukühlenden oder zu erwärmendem Organ, dadurch gekennzeichnet, daß sie
einen Flüssigkeitsbehälter (1), welcher mit dem atmosphärischen Druck in Verbindung steht,
einen umschlossenen Raum, der an seinem unteren Teil in den genannten Behälter (1) mündet und dessen Innenfläche wenigstens teilweise durch das genannte abzukühlende oder zu erwärmende Organ (14a, 14b) gebildet wird, sowie
eine Vakuumpumpe (4), die auf die genannte Flüssigkeit einwirkt und deren Druck in bezug auf den atmosphärischen Druck herabsetzt,
aufweist.

2. Anlage nach Anspruch 1, dadurch gekennzeichnet, daß sie eine Steigleitung (3) aufweist, an deren unteren und oberen Teil jeweils eine Zuleitung (6) bzw. eine Ablaufleitung (7) angeschlossen ist, wobei der umschlossene Raum mit Kästen (8a, 8b usw.) ausgestattet ist, die über Leitungen (10a, 10b usw.; 11a, 11b usw.) mit Zuleitungen (6) und Ablaufleitungen (7) verbunden sind, und wobei der obere Teil der Steigleitung (3) die Vakuumpumpe (4) aufweist.

3. Anlage nach Anspruch 1, dadurch gekennzeichnet, daß die Vakuumpumpe (4) von einem Flüssigkeitsstandsregler (5) gesteuert wird.
